# EUROPEAN PATENT APPLICATION

(11) **EP 1 502 695 A1**
(43) Date of publication of application: **02.02.2005**
(21) Application number: 03717689.8
(22) Date of filing: 22.04.2003
(51) Int. Cl.: B23K 26/06, H01L 21/301

(54) **FINISHING MACHINE USING LASER BEAM**

(30) Priority: 07.05.2002 JP 2002131776
(71) Applicant: Disco Corporation, Ota-ku, Tokyo 144-8650 (JP)
(72) Inventor: TAKEUCHI, Masaya, DISCO CORPORATION, Tokyo 144-8650 (JP); KANEUCHI, Yasuomi, DISCO CORPORATION, Tokyo 144-8650 (JP); NAGAI, Yusuke, DISCO CORPORATION, Tokyo 144-8650 (JP)
(74) Representative: Müller-Boré & Partner Patentanwälte
(86) International application number: PCT/JP2003/005086
(87) International publication number: WO 2003/095139

(57) **Abstract**

A machining device comprises laser beam machining means for shining a laser beam to a workpiece. The laser beam machining means includes laser beam oscillation means, laser beam modulation means, and laser beam shining means. The laser beam modulation means includes laser beam pulse width setting means for converting the laser beam oscillated by the laser beam oscillation means into a pulse laser having a pulse width of 1,000 ps or less.

## Description

### Technical Field

This invention relates to a machining device for shining a laser beam to a workpiece to machine the workpiece. More specifically, the invention relates to, but is not limited to, a machining device suitable for removing a low dielectric constant insulator, laminated on the face of a semiconductor wafer, along predetermined lines.

### Background Art

In the manufacture of semiconductor chips, as is well known among people skilled in the art, a plurality of rectangular regions are defined on the face of a semiconductor wafer by streets arranged in a lattice pattern, and a semiconductor circuit is formed in each of the rectangular regions. This semiconductor wafer is cut along the streets to separate the rectangular regions individually, thereby forming semiconductor chips. For cutting along the streets of the semiconductor wafer, a machining device called a dicer is usually used. Such a machining device comprises workpiece holding means for holding a workpiece, namely, a semiconductor wafer, cutting means for cutting the semiconductor wafer held by the workpiece holding means, and moving means for moving the workpiece holding means and the cutting means relative to each other. The cutting means includes a rotatably mounted spindle, a cutting blade mounted on the spindle, and a rotational drive source for rotating the spindle. As the cutting blade, there is advantageously used a thin disk-shaped blade, called a diamond blade, which can be formed by binding diamond grains with a nickel plating or a suitable bond, such as a resin bond.

In recent times, a semiconductor wafer having a low dielectric constant insulator laminated on the face of a semiconductor wafer body, such as a silicon wafer, has been put to practical use. Examples of the low dielectric constant insulator are films of materials having a lower dielectric constant (e.g., dielectric constant k = about 2.5 to 3.6) than that of an Si0₂ film (k = about 4.1), for example, a film of an inorganic material such as SiOF, BSG (SiOB) or H-containing polysiloxane (HSQ), a film of an organic material, such as a polyimide-based or parylene-based or polytetrafluoroethylene-based polymer film, and a porous silica film comprising methyl-containing polysiloxane or the like. Assume that such a semiconductor wafer is cut with the aforementioned machining device called a dicer, that is, cut by the action of the cutting blade called a diamond blade. In this case, there is a tendency toward the occurrence of the impermissible event that a surface layer, i.e. a low dielectric constant insulator layer, peels off the semiconductor wafer body even in regions adjacent to the streets, owing to the marked brittleness of the low dielectric constant insulator. Thus, before cutting of the semiconductor wafer by the machining device called a dicer, it is attempted to remove the low dielectric constant insulator by shining a laser beam to the streets.

According to the conventional machining device which directs a laser beam at the semiconductor wafer as the workpiece, the low dielectric constant insulator can be removed along the streets. However, the semiconductor wafer is heated to a considerably high temperature and melted. As a result, the semiconductor circuit is found to show a tendency to deteriorate.

### Disclosure of the Invention

Therefore, a principal object of the present invention is to provide a novel and improved machining device which, when applied to a semiconductor wafer having a low dielectric constant insulator laminated on its face, can remove a surface layer, i.e. the low dielectric constant insulator, along streets without deteriorating a semiconductor circuit.

We, the inventors of the present invention, conducted in-depth studies and experiments, and have found that the above object can be attained by using a pulse laser beam with a pulse width set at a sufficiently small value, as a laser beam shone to a workpiece.

According to the present invention, as a machining device capable of attaining the above object, there is provided a machining device comprising: workpiece holding means for holding a workpiece; laser beam machining means for shining a laser beam to the workpiece held by the workpiece holding means to machine the workpiece; and moving means for moving the workpiece held by the workpiece holding means, and a laser beam shone to the workpiece relative to each other,
the laser beam machining means including laser beam oscillation means, laser beam modulation means for modulating a laser beam oscillated by the laser beam oscillation means, and laser beam shining means for shining the laser beam modulated by the laser beam modulation means to the workpiece held by the workpiece holding means, and characterized in that
the laser beam modulation means includes laser beam pulse width setting means for converting the laser beam oscillated by the laser beam oscillation means into a pulse laser beam having a pulse width of 1,000 ps (picoseconds) or less.

Preferably, the laser beam pulse width setting means converts the oscillated laser beam into a pulse laser beam having a pulse width of 1 to 500 ps (picoseconds). The laser beam modulation means preferably includes laser beam wavelength setting means for setting the laser beam oscillated by the laser beam oscillation means to be a pulse laser beam having a wavelength of 200 to 600 nm. The laser beam shining means preferably includes spot diameter setting means for setting the spot diameter of the pulse laser beam shone to the workpiece at 5 to 100 µm. Preferably, the laser beam modulation means includes pulse repetition frequency setting means for converting the laser beam oscillated by the laser beam oscillation means into a pulse laser beam having a pulse repetition frequency of 0.01 to 100 KHZ. The laser beam oscillation means may be a YAG laser oscillator or a YV04 laser oscillator. The moving means preferably moves the workpiece and the laser beam relative to each other such that the number of overlaps of the pulse laser beam shone to a machining region for the workpiece is 2 to 5. The moving means advantageously moves the workpiece holding means at a feed speed of 1 to 1,000 mm/second. In preferred embodiments, the machining device is equipped with cutting means including a rotatably mounted spindle, a cutting blade mounted on the spindle, and a rotational drive source for rotating the spindle; the workpiece is a semiconductor wafer having a low dielectric constant insulator laminated on the face thereof; and the low dielectric constant insulator is cut along a predetermined line by the laser beam machining means, and then a semiconductor wafer body is cut along the predetermined line by the rotated cutting blade of the cutting means.

### Brief Description of the Drawings

FIG. 1 is a perspective view showing main constituent elements in a preferred embodiment of a machining device constructed according to the present invention.
FIG. 2 is a perspective view showing an example of a semiconductor wafer which is a workpiece.
FIG. 3 is a diagrammatic view schematically showing the constitution of laser beam machining means in the machining device of FIG. 1.
FIG. 4 is an abridged diagrammatic view schematically showing a pulse laser beam shone to a street when the semiconductor wafer is machined by the machining device of FIG. 1.
FIG. 5 is a perspective view showing main constituent elements in another preferred embodiment of a machining device constructed according to the present invention.

### Best Mode for Carrying out the Invention

The present invention will now be described in greater detail by reference to the accompanying drawings which illustrate the preferred embodiments of a machining device constructed in accordance with the present invention.

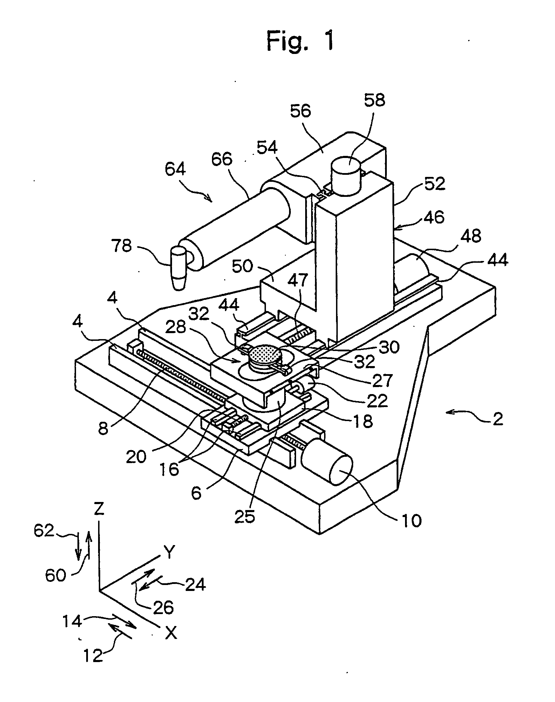

FIG. 1 shows a principal portion of a preferred embodiment of the machining device constructed according to the present invention. The illustrated machining device has a support plate 2, and a pair of guide rails 4 extending in an X-axis direction are disposed on the support plate 2. A first slide block 6 is mounted on the guide rails 4 so as to be movable in the X-axis direction. A threaded shaft 8 extending in the X-axis direction is rotatably mounted between the pair of guide rails 4, and an output shaft of a pulse motor 10 is connected to the threaded shaft 8. The first slide block 6 has a downward portion (not shown) extending downwardly, and an internally threaded hole piercing in the X-axis direction is formed in the downward portion. The threaded shaft 8 is screwed to the internally threaded hole. Thus, when the pulse motor 10 is rotated in a normal direction, the first slide block 6 is moved in a direction indicated by an arrow 12. When the pulse motor 10 is rotated in a reverse direction, the first slide block 6 is moved in a direction indicated by an arrow 14. As will become apparent from descriptions to be given later, the pulse motor 10 and the threaded shaft 8 constitute moving means for moving a workpiece (relative to laser beam machining means).

A pair of guide rails 16 extending in a Y-axis direction are disposed on the first slide block 6. A second slide block 18 is mounted on the guide rails 16 so as to be movable in the Y-axis direction. A threaded shaft 20 extending in the Y-axis direction is rotatably mounted between the pair of guide rails 16, and an output shaft of a pulse motor 22 is connected to the threaded shaft 20. An internally threaded hole piercing in the Y-axis direction is formed in the second slide block, and the threaded shaft 20 is screwed to the internally threaded hole. Thus, when the pulse motor 22 is rotated in a normal direction, the second slide block 18 is moved in a direction indicated by an arrow 24. When the pulse motor 22 is rotated in a reverse direction, the first slide block 18 is moved in a direction indicated by an arrow 26. A support table 27 is fixed to the second slide block 18 via a cylindrical member 25, and holding means 28 is also mounted on the second slide block 18 via the cylindrical member 25. The holding means 28 is mounted so as to be rotatable about a central axis extending substantially vertically. A pulse motor (not shown) for rotating the holding means 28 is disposed within the cylindrical member 25. The holding means 28 in the illustrated embodiment is composed of a chuck plate 30 formed from a porous material, and a pair of gripping means 32.

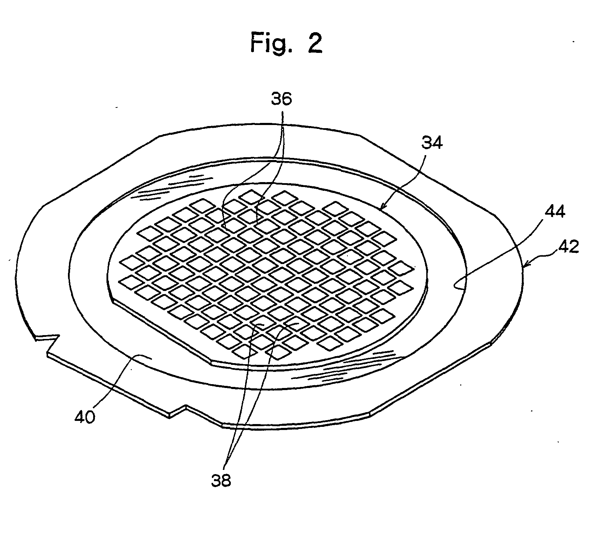

FIG. 2 shows a semiconductor wafer 34 which is a workpiece. The semiconductor wafer 34 is of a form having a low dielectric constant insulator laminated on the face of a semiconductor wafer body such as a silicon wafer. Streets 36 are formed in a lattice pattern on the face, and a plurality of rectangular regions 38 are demarcated by the streets 36. A semiconductor circuit is formed in each of the rectangular regions 38. In the illustrated embodiment, the semiconductor wafer 34 is mounted on a frame 42 via a mounting tape 40. The frame 42, which can be formed from a suitable metal or synthetic resin, has a relatively large circular opening 44 at the center, and the semiconductor wafer 34 is positioned in the opening 44. The mounting tape 40 extends on lower surfaces of the frame 42 and the semiconductor wafer 34 across the opening 44 of the frame 42, and is stuck to the lower surfaces of the frame 42 and the semiconductor wafer 34. In machining the semiconductor wafer 34, the semiconductor wafer 34 is located on the chuck plate 30 in the holding means 28, and the chuck plate 30 is brought into communication with a vacuum source (not shown), whereby the semiconductor wafer 34 is vacuum attracted onto the chuck plate 30. The pair of gripping means 32 of the holding means 28 grip the frame 32. The holding means 28 itself, and the semiconductor wafer 34 itself mounted on the frame 42 via the mounting tape 40 may be in forms well known among people skilled in the art, and thus detailed explanations for them will be omitted herein.

Referring to FIG. 1 again, a pair of guide rails 44 extending in the Y-axis direction are disposed on the support plate 2. A third slide block 46 is mounted on the pair of guide rails 44 so as to be movable in the Y-axis direction. A threaded shaft 47 extending in the Y-axis direction is rotatably mounted between the pair of guide rails 44, and an output shaft of a pulse motor 48 is connected to the threaded shaft 47. The third slide block 46 is nearly L-shaped, and has a horizontal base portion 50, and an upright portion 52 extending upwardly from the horizontal base portion 50. The horizontal base portion 50 has a downward portion (not shown) extending downwardly, and an internally threaded hole piercing in the Y-axis direction is formed in the downward portion. The threaded shaft 47 is screwed to the internally threaded hole. Thus, when the pulse motor 48 is rotated in a normal direction, the third slide block 46 is moved in the direction indicated by the arrow 24. When the pulse motor 48 is rotated in a reverse direction, the third slide block 46 is moved in the direction indicated by the arrow 26.

A pair of guide rails 54 (only one of them is shown in FIG. 1) extending in a Z-axis direction are disposed on one side surface of the upright portion 52 of the third slide block 46. A fourth slide block 56 is mounted on the pair of guide rails 54 so as to be movable in the Z-axis direction. A threaded shaft (not shown) extending in the Z-axis direction is rotatably mounted on one side surface of the third slide block 46, and an output shaft of a pulse motor 58 is connected to the threaded shaft. A protrusion (not shown) projecting toward the upright portion 52 is formed in the fourth slide block 56, and an internally threaded hole piercing in the Z-axis direction is formed in the protrusion. The above-mentioned threaded shaft is screwed to this internally threaded hole. Thus, when the pulse motor 58 is rotated in a normal direction, the fourth slide block 56 is moved in a direction indicated by an arrow 60, namely, upward. When the pulse motor 58 is rotated in a reverse direction, the fourth slide block 56 is moved in a direction indicated by an arrow 62, namely, downward.

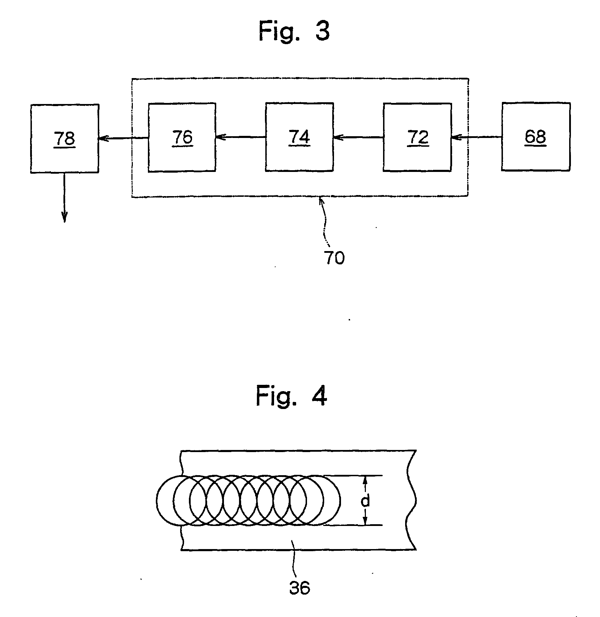

Laser beam machining means, indicated entirely at a numeral 64, is mounted on the fourth slide block 56. The illustrated laser beam machining means 64 includes a casing 66 of a cylindrical shape fixed to the fourth slide block 56 and extending forward (i.e. in the direction indicated by the arrow 26) substantially horizontally. Further with reference to FIG. 3 along with FIG. 1, laser beam oscillation means 68 and laser beam modulation means 70 are disposed within the casing 66. The laser beam oscillation means 68 is advantageously a YAG laser oscillator or a YV04 laser oscillator. The laser beam modulation means 70 includes pulse repetition frequency setting means 72, laser beam pulse width setting means 74, and laser beam wavelength setting means 76. The pulse repetition frequency setting means 72, laser beam pulse width setting means 74, and laser beam wavelength setting means 76 constituting the laser beam modulation means 70 may be of forms well known among people skilled in the art, and thus detailed explanations for their constitutions are omitted herein. Laser beam shining means 78, which may be of a well-known form per se, is mounted at the front end of the casing 66.

A laser beam oscillated by the laser beam oscillation means 68 arrives at the laser beam shining means 78 via the laser beam modulation means 70. In the laser beam modulation means 70, the pulse repetition frequency setting means 72 converts the laser beam into a pulse laser beam of a predetermined pulse repetition frequency, the laser beam pulse width setting means 74 sets the pulse width of the pulse laser beam at a predetermined width, and the laser beam wavelength setting means sets the wavelength of the pulse laser beam at a predetermined value. According to our experiments, it is important that the pulse width of the pulse laser beam is 1,000 ps (picoseconds) or less, preferably 1 to 500 ps. If the pulse width is too large, the semiconductor wafer 34 irradiated with the laser beam tends to be heated to a considerably high temperature and melted. The pulse repetition frequency is preferably 0.01 to 100 KHZ. The wavelength of the pulse laser beam is preferably 200 to 600 nm.

The laser beam, which has been modulated, as required, by the laser beam modulation means 70 and has arrived at the laser beam shining means 78, is shone to the semiconductor wafer 34 held on the holding means 28. In further detail, according to the illustrated embodiment, the position of the street 36 of the semiconductor wafer 34 held on the holding means 28 is detected sufficiently accurately by suitable alignment means (not shown), whereby the holding means 28 is positioned with respect to the laser beam shining means 78 so that the laser beam shot downward from the laser beam shining means 78 will reach a particular street 36. With the pulse laser beam being shone toward the semiconductor wafer 34 from the laser beam shining means 78, the holding means 28, accordingly the semiconductor wafer 34 held thereby, is moved at a predetermined speed in the direction, for example, indicated by the arrow 12. Thus, the pulse laser beam is shone along the specific street 36, whereby the low dielectric constant insulator laminated on the surface of the particular street 36 is removed. As shown in FIG. 4, the spot diameter, d, of the pulse laser beam shone onto the street 36 of the semiconductor wafer 34 is preferably of the order of 5 to 100 µm. Preferably, the moving speed of the semiconductor wafer 34 is of the order of 1 to 1,000 mm/second, and the number of overlaps of the spots of the pulse laser beam shone to the street 36 is about 2 to 5. That is, it is preferred for the pulse laser beam to be shone to the street 36 repeatedly, two to five times. If the number of overlaps of the spots of the pulse laser beam is too small, the low dielectric constant insulator is removed insufficiently. If the number of overlaps is too large, on the other hand, the semiconductor wafer 34 tends to be heated excessively.

After the semiconductor wafer 34 is moved in the direction indicated by the arrow 12 to complete the removal of the low dielectric constant insulator in the particular street 36, the holding means 28, accordingly the semiconductor wafer 34, is indexed by the spacing between the streets 36 in the direction indicated by the arrow 26 (or 24). Then, the holding means 28, accordingly the semiconductor wafer 34, is moved in the direction indicated by the arrow 14, with the pulse laser beam being shone to the next street 36. Thus, the low dielectric constant insulator on the next street 36 is removed. After the low dielectric constant insulator on all the streets 36 extending in the particular direction has been removed in this manner, the holding means 28, accordingly the semiconductor wafer 34, is turned 90 degrees. Then, the low dielectric constant insulator on the streets 36 extending perpendicularly to the aforementioned particular direction is removed similarly. In the illustrated embodiment, when the pulse laser beam is shone to the street 36 of the semiconductor wafer 34, the semiconductor wafer 34 held by the holding means 28 is moved. If desired, however, the laser beam shining means 78 can be moved instead. Alternatively, instead of indexing the semiconductor wafer 34 held by the holding means 28, the laser beam shining means 78 can be indexed. However, the movement of the laser beam shining means 78 may result in poor accuracy because of vibrations. Thus, it is preferred that the laser beam shining means 78 is kept stationary, and the holding means 28, accordingly the semiconductor wafer 34 held thereby, is moved as desired.

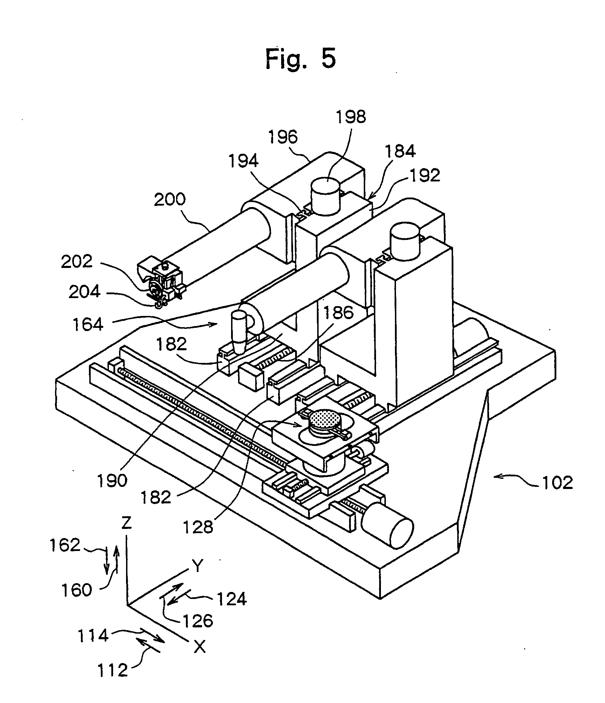

FIG. 5 shows another preferred embodiment of a machining device constructed in accordance with the present invention. In the embodiment illustrated in FIG. 5, cutting means 180 is also disposed on a support plate 102, in addition to holding means 128 and laser beam machining means 164. The holding means 128 itself and its manner of mounting, and the laser beam machining means 164 itself and its manner of mounting are substantially the same as in the embodiment shown in FIG. 1. Thus, their explanations will be omitted.

The cutting means 180 is described. A pair of guide rails 182 extending in a Y-axis direction are disposed on the support plate 102. A fifth slide block 184 is mounted on the pair of guide rails 182 so as to be movable in the Y-axis direction. A threaded shaft 186 extending in the Y-axis direction is rotatably mounted between the pair of guide rails 182, and an output shaft of a pulse motor (not shown) is connected to the threaded shaft 186. The fifth slide block 184 is nearly L-shaped, and has a horizontal base portion 190, and an upright portion 192 extending upwardly from the horizontal base portion 190. The horizontal base portion 190 has a downward portion (not shown) extending downwardly, and an internally threaded hole piercing in the Y-axis direction is formed in the downward portion. The threaded shaft 186 is screwed to the internally threaded hole. Thus, when the pulse motor is rotated in a normal direction, the fifth slide block 184 is moved in a direction indicated by an arrow 124. When the pulse motor is rotated in a reverse direction, the fifth slide block 184 is moved in a direction indicated by an arrow 126.

A pair of guide rails 194 (only one of them is shown in FIG. 5) extending in a Z-axis direction are disposed on one side surface of the upright portion 192 of the fifth slide block 184. A sixth slide block 196 is mounted on the pair of guide rails 194 so as to be movable in the Z-axis direction. A threaded shaft (not shown) extending in the Z-axis direction is rotatably mounted on one side surface of the fifth slide block 184, and an output shaft of a pulse motor 198 is connected to the threaded shaft. A protrusion (not shown) projecting toward the upright portion 192 is formed in the sixth slide block 196, and an internally threaded hole piercing in the Z-axis direction is formed in the protrusion. The above-mentioned threaded shaft is screwed to this internally threaded hole. Thus, when the pulse motor 198 is rotated in a normal direction, the sixth slide block 196 is moved in a direction indicated by an arrow 160, namely, upward. When the pulse motor 198 is rotated in a reverse direction, the sixth slide block 196 is moved in a direction indicated by an arrow 162, namely, downward.

The cutting means 180 includes a casing 200 mounted on the above-mentioned sixth slide block 196. A spindle (not shown) extending in the Y-axis direction is rotatably mounted within the casing 200. A cutting blade 202 is mounted at a front end portion of the spindle. An electric motor, i.e. a rotational drive source (not shown), for rotating the spindle at a high speed is disposed within the casing 200. The cutting blade 202 is preferably a thin disk-shaped blade formed by binding diamond grains with a nickel plating or a suitable bond, such as a resin bond. Cooling liquid jetting means 204 for jetting a cooling liquid, which may be pure water, is disposed at the front end of the casing 200.

In the embodiment illustrated in FIG. 5, the laser beam machining means 164 is first caused to act on the semiconductor wafer 34 (FIG. 2) held on the holding means 128. As a result, the low dielectric constant insulator laminated on the surface of the street 36 of the semiconductor wafer 34 is removed in substantially the same manner as in the embodiment shown in FIG. 1. Then, the cutting means 180 is caused to act on the semiconductor wafer 34 held on the holding means 128. As a result, the body of the semiconductor wafer 34 is cut along the street 36. In this manner, the rectangular region 40 of the semiconductor wafer 34 is separated to form a semiconductor chip. In cutting the semiconductor wafer 34 by the cutting means 180, the particular street 36 of the semiconductor wafer 34 is positioned sufficiently accurately with respect to the cutting blade 202 of the cutting means 180. Moreover, the height, i.e. the position in the Z-axis direction, of the cutting blade 202 is set such that the cutting blade 202 is located at a predetermined height (namely, such that the lower end of the outer peripheral edge of the cutting blade 202 agrees sufficiently accurately with the lower surface of the semiconductor wafer 34 held on the holding means 128). Then, the cutting blade 202 is rotated at a high speed, and the holding means 128, accordingly the semiconductor wafer 34, is moved in a direction indicated by an arrow 112. Thus, the semiconductor wafer 34 is cut along the particular street 36. The mounting tape 40 (FIG. 2), which has mounted the semiconductor wafer 34 on the frame 42 (FIG. 2), is kept remaining without being cut. Then, the cutting blade 202 is lifted over a distance greater than the thickness of the semiconductor wafer 34, and the holding means 128, accordingly the semiconductor wafer 34, is moved as a return motion in a direction indicated by an arrow 114. Then, the cutting blade 202 (or the holding means 128) is indexed by the spacing between the streets 36 in the direction indicated by the arrow 124 (or 126). Then, the cutting blade 202 is lowered, and positioned again at the predetermined height. The cutting blade 202 is rotated at a high speed, and the holding means 128, accordingly the semiconductor wafer 34, is moved in the direction indicated by the arrow 112. Thus, the semiconductor wafer 34 is cut along the next street 36. After the semiconductor wafer 34 is so cut along all the streets 36 extending in the particular direction, the holding means 128, accordingly the semiconductor wafer 34, is turned 90 degrees. Then, the semiconductor wafer 34 is similarly cut along the streets 36 extending perpendicularly to the above-mentioned particular direction.

The preferred embodiments of the machining device constructed in accordance with the present invention have been described in detail above with reference to the accompanying drawings. However, it should be understood that the present invention is not limited to these embodiments, and various modifications and corrections may be made without departing from the scope of the present invention.

## Claims

1. A machining device comprising: workpiece holding means for holding a workpiece; laser beam machining means for shining a laser beam to the workpiece held by said workpiece holding means to machine the workpiece; and moving means for moving the workpiece held by said workpiece holding means, and a laser beam shone to the workpiece relative to each other,
said laser beam machining means including laser beam oscillation means, laser beam modulation means for modulating a laser beam oscillated by said laser beam oscillation means, and laser beam shining means for shining the laser beam modulated by said laser beam modulation means to the workpiece held by said workpiece holding means, and **characterized in that**
said laser beam modulation means includes laser beam pulse width setting means for converting the laser beam oscillated by said laser beam oscillation means into a pulse laser beam having a pulse width of 1,000 ps (picoseconds) or less.

2. The machining device according to claim 1, wherein said laser beam pulse width setting means converts the oscillated laser beam into a pulse laser beam having a pulse width of 1 to 500 ps (picoseconds).

3. The machining device according to claim 1, wherein said laser beam modulation means includes laser beam wavelength setting means for setting the laser beam oscillated by said laser beam oscillation means to be a pulse laser beam having a wavelength of 200 to 600 nm.

4. The machining device according to claim 1, wherein said laser beam shining means includes spot diameter setting means for setting the spot diameter of the pulse laser beam shone to the workpiece at 5 to 100 µm.

5. The machining device according to claim 1, wherein said laser beam modulation means includes pulse repetition frequency setting means for converting the laser beam oscillated by said laser beam oscillation means into a pulse laser beam having a pulse repetition frequency of 0.01 to 100 KHZ.

6. The machining device according to claim 1, wherein said laser beam oscillation means is a YAG laser oscillator.

7. The machining device according to claim 1, wherein said laser beam oscillation means is a YVO4 laser oscillator.

8. The machining device according to claim 1, wherein said moving means moves the workpiece and the laser beam relative to each other such that the number of overlaps of the pulse laser beam shone to a machining region for the workpiece is 2 to 5.

9. The machining device according to claim 8, wherein said moving means moves said workpiece holding means at a feed speed of 1 to 1,000 mm/second.

10. The machining device according to claim 1, which is equipped with cutting means including a rotatably mounted spindle, a cutting blade mounted on said spindle, and a rotational drive source for rotating said spindle; the workpiece is a semiconductor wafer having a low dielectric constant insulator laminated on a face thereof; and said low dielectric constant insulator is cut along a predetermined line by said laser beam machining means, and then a semiconductor wafer body is cut along said predetermined line by said rotated cutting blade of said cutting means.
